# EUROPEAN PATENT APPLICATION

(11) **EP 1 990 911 A1**
(43) Date of publication of application: **12.11.2008**
(21) Application number: 07251919.2
(22) Date of filing: 09.05.2007
(51) Int. Cl.: H03B 5/04, H03L 1/04, H03H 9/19

(54) **Crystal oscillator device capable of maintaining constant temperature condition**

(71) Applicant: Taitien Electronics Co., Ltd., Taipei (TW)
(72) Inventor: Lee, Tung-Thei, Taipei (TW)
(74) Representative: Neill, Alastair William

(57) **Abstract**

A crystal oscillator device (2) includes a package housing (21) having conductive coupling seats (215) disposed fixedly in a vacuum chamber (214) thereof, and conductive contacts (218) exposed outwardly of the package housing (21). Each conductive coupling seat (215) is connected electrically to a corresponding conductive contact (218). A circuit board (22) is disposed in the vacuum chamber (214), and has terminals (221) connected electrically and respectively to the conductive coupling seats (215). A crystal oscillator (23) is mounted on a first surface (222) of the circuit board (22). A heating control circuit (24) is mounted on a second surface (223) of the circuit board (22) for heating the vacuum chamber (214) in accordance with variation of the temperature in the vacuum chamber (214) so as to maintain the temperature in the vacuum chamber (214) at a predetermined temperature.

## Description

The invention relates to a crystal oscillator device, more particularly to a crystal oscillator device capable of maintaining a constant temperature condition.

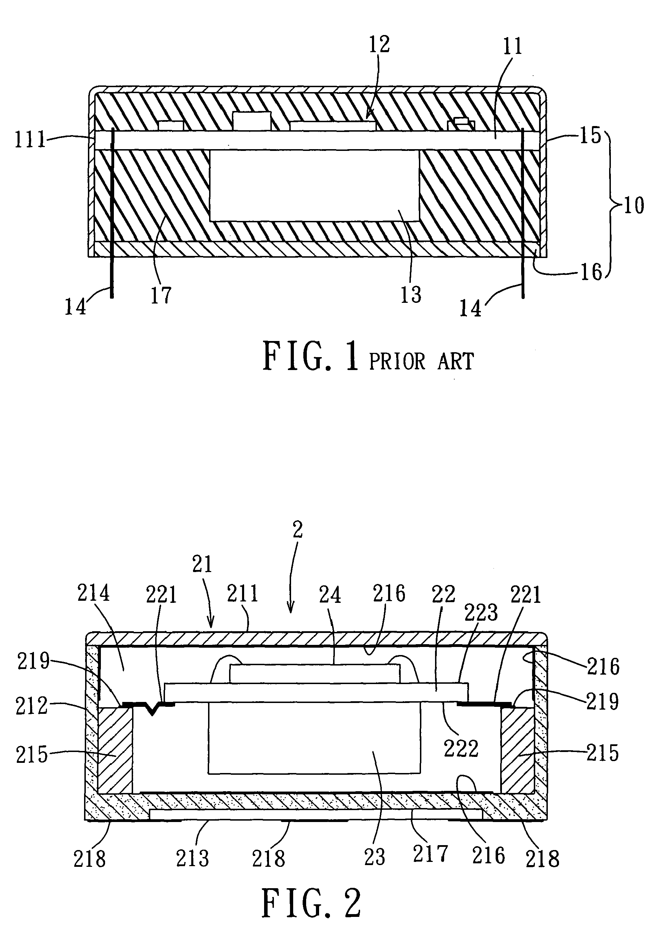

Figure 1 illustrates a conventional crystal oscillator device that can generate a predetermined oscillating frequency under constant temperature condition as a standard frequency for a global positioning system equipment, a mobile communication system and a wireless system. The conventional crystal oscillator device includes a package housing 10, a circuit board 11, a heating circuit 12 and a crystal oscillator 13. The package housing 10 has a base plate 16, such as a printed circuit board, and a metal cover 15 for covering sealingly the base plate 16. The base plate 16 cooperates with the cover 15 to define a chamber therebetween. The package housing 10 has a size of 50.8mm×50.8mm×17.27mm. The circuit board 11 is disposed fixedly in the chamber, and has an annular surrounding surface 111 in contact with the cover 15. The crystal oscillator 13 is mounted on a bottom surface of the circuit board 11. The heating circuit 12 is mounted on a top surface of the circuit board 11 for heating the chamber in accordance with variation of the temperature in the chamber so as to maintain the temperature in the chamber at a predetermined temperature, thereby ensuring that the crystal oscillator 13 can generate a predetermined oscillating frequency. The circuit board 11 has a plurality of connecting pins 14 extending outwardly of the package housing 10 through the base plate 16. A foam material 17 is filled within the chamber.

Since the circuit board 11 contacts the cover 15, heat generated by the heating circuit 12 is dissipated via the circuit board 11, the cover 15, the connecting pins 14 and the base plate 16. As a result, frequent actuation of the heating circuit 12 is required to maintain the chamber in a constant temperature condition, thereby resulting in increased power consumption.

Therefore, the object of the present invention is to provide a crystal oscillator device that can overcome the aforesaid drawbacks of the prior art.

According to the present invention, a crystal oscillator device comprises:
a package housing configured with a vacuum chamber and having a plurality of conductive coupling seats that are disposed fixedly in the vacuum chamber and that are spaced apart from each other, and a plurality of conductive contacts that are exposed outwardly of the package housing, each of the conductive coupling seats being connected electrically to a corresponding one of the conductive contacts;
a circuit board disposed in the vacuum chamber and having opposite first and second surfaces, and a plurality of terminals connected electrically and respectively to the conductive coupling seats of the package housing;
a crystal oscillator mounted on the first surface of the circuit board; and
a heating control circuit mounted on the second surface of the circuit board for heating the vacuum chamber in accordance with variation of the temperature in the vacuum chamber so as to maintain the temperature of the vacuum chamber at a predetermined temperature.

Other features and advantages of the present invention will become apparent in the following detailed description of the preferred embodiment with reference to the accompanying drawings, of which:
Figure 1 is a schematic partly sectional view of a conventional crystal oscillator device;
Figure 2 is a schematic partly sectional view showing the preferred embodiment of a crystal oscillator device according to the present invention;
Figure 3 is a schematic partly sectional, top view showing the preferred embodiment; and
Figure 4 is a schematic bottom view showing the preferred embodiment.

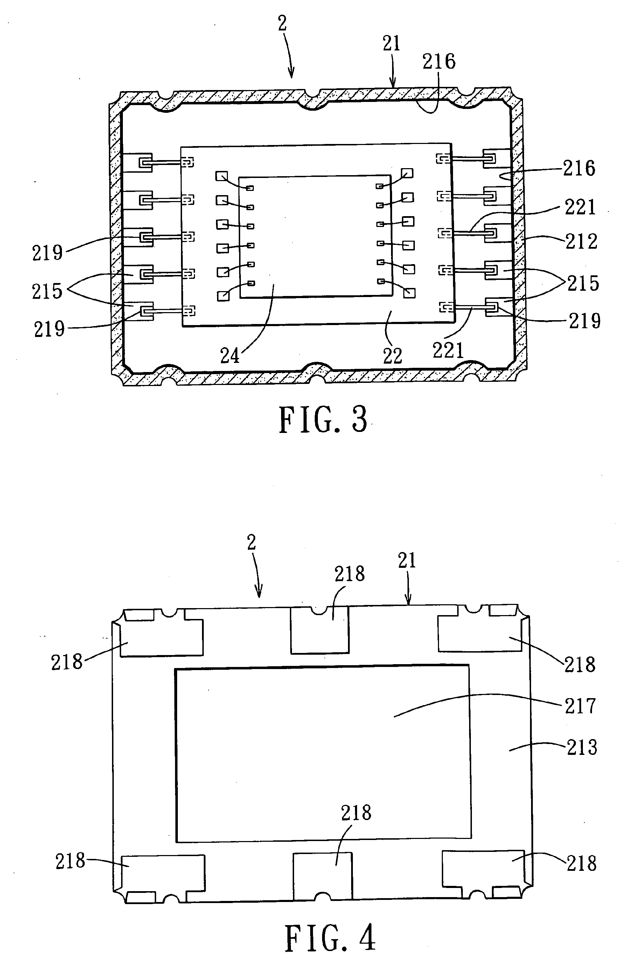

Referring to Figures 2 and 3, thepreferredembodiment of a crystal oscillator device 2 according to the present invention is shown to include a package housing 21, a circuit board 22, a crystal oscillator 23, and a heating control circuit 24.

The package housing 21 has a ceramic hollow base 212, a metal cover 211 for covering sealingly the base 212 in a seam seal manner such that the base 212 cooperates with the cover 211 to define a vacuum chamber therebetween, a plurality of conductive coupling seats 215 di sposed fixedly in the vacuum chamber 214 and spaced apart from each other, and a plurality of conductive contacts 218 exposed outwardly of the package housing 21. Each of the conductive coupling seats 215 is connected electrically and wiredly to a corresponding one of the conductive contacts 218. In this embodiment, the package housing 21 has an inner surface formed with a metal-plated heat radiation blocking layer 216 (see Figure 2). The base 212 has an outer bottom surface 213 formed with the conductive contacts 218. The conductive contacts 218 are disposed spacedly along a periphery of the outer bottom surface 213, and the outer bottom surface 213 of the base 212 is formed with a central recess 217, as best shown in Figure 4. The conductive contacts 218 are adapted to be connected electrically to an external circuit board (not shown) using surface mounting techniques. Due to the presence of the central recess 217, the package housing 21 has a decreased contact area in contact with the external circuit board when the crystal oscillator device 2 is mounted on the external circuit board. In this embodiment, each of the conductive coupling seats 215 has a conductive pad 219 connected electrically and wiredly to the corresponding one of the conductive contacts 218 on the outer bottom surface 213 of the base 212.

The circuit board 22 is disposed in the vacuum chamber 214, and has top and bottom surfaces 223, 222, and a plurality of terminals connected electrically and respectively to the conductive coupling seats 215. In this embodiment, the terminals are in the form of leads 221, each of which interconnects electrically the circuit board 22 and the corresponding one of the conductive pads 219 of the conductive coupling seats 215. The leads 221 are made of an alloy of beryllium and copper.

The crystal oscillator 23 is mounted on the bottom surface 222 of the circuit board 22.

The heating control circuit 24 is mounted on the top surface 223 of the circuit board 22 for heating the vacuum chamber 214 in accordance with variation of the temperature in the vacuum chamber 214 so as to maintain the temperature in the vacuum chamber 214 at a predetermined temperature, thereby ensuring that the crystal oscillator 22 can generate a predetermined oscillating frequency. In this embodiment, the heating control circuit 24 is in the form of a semiconductor integrated circuit (IC), such as a monolithic IC, having a small size. Therefore, the size of the circuit board 22 can be reduced, thereby resulting in a relatively small volume of the package housing 21 (for example, 7. 5mm×5.0mm×2.9mm) as compared to that of the aforesaid conventional crystal oscillator device (for example, 50.8mm×50.8mm×17.27mm).

In such a configuration, since the circuit board 22 does not contact the package housing 21, heat dissipation can be minimized. Furthermore, heat convection can be avoided in the vacuum chamber 214, and due to the presence of the heat radiation blocking layer 216, heat radiation from the vacuum chamber 214 can be avoided. The package housing 21 has a relatively small size. As a result, the heating control circuit 24 can maintain effectively the temperature in the vacuum chamber 214 at the predetermined temperature with decreased power consumption.

## Claims

1. A crystal oscillator device (2) **characterized by**:
a package housing (21) configured with a vacuum chamber (214) and having a plurality of conductive coupling seats (215) that are disposed fixedly in said vacuum chamber (214) and that are spaced apart from each other, and a plurality of conductive contacts (218) that are exposed outwardly of said package housing (21), each of said conductive coupling seats (215) being connected electrically to a corresponding one of said conductive contacts (218) ;
a circuit board (22) disposed in said vacuum chamber (214) and having opposite first and second surfaces, and a plurality of terminals (221) connected electrically and respectively to said conductive coupling seats (215) of said package housing (21);
a crystal oscillator (23) mounted on said first surface of said circuit board (22); and
a heating control circuit (24) mounted on said second surface of said circuit board (22) for heating said vacuum chamber (214) in accordance with variation of the temperature in said vacuum chamber (214) so as to maintain the temperature in said vacuum chamber (214) at a predetermined temperature.

2. The crystal oscillator device as claimed in Claim 1, **characterized in that** said terminals of said circuit board (22) are in the form of leads (221), each of which interconnects electrically said circuit board (22) and the corresponding one of said conductive coupling seats (215) .

3. The crystal oscillator device as claimed in Claim 2, further **characterized in that** said leads (221) are made of an alloy of beryllium and copper.

4. The crystal oscillator device as claimed in Claim 2, further **characterized in that** each of said conductive coupling seats (215) has a conductive pad (219) connected electrically and wiredly to the corresponding one of said conductive contacts (218) of said package housing (21), and connected electrically to a corresponding one of said leads (221) of said circuit board (22).

5. The crystal oscillator device as claimed in Claim 1, **characterized in that** said package housing (21) has a hollow base (212), and a cover (211) for covering sealingly said base (212), said base (212) cooperating with said cover (211) to define said vacuum chamber (214) therebetween, said base (212) having an outer bottom surface (213) formed with said conductive contacts (218).

6. The crystal oscillator device as claimed in Claim 5, further **characterized in that** said conductive contacts (218) are disposed spacedly along a periphery of said outer bottom surface (213) of said base (212), said outer bottom surface (213) of said base (212) being formed with a central recess (217).

7. The crystal oscillator device as claimed in Claim 1, **characterized in that** said package housing (21) has an inner surface formed with a metal-plated heat radiation blocking layer (216).

8. The crystal oscillator device as claimed in Claim 1, **characterized in that** said heating control circuit (24) is in the form of an integrated circuit.

9. The crystal oscillator device as claimed in Claim 1, **characterized in that** said first and second surfaces of said circuit board (22) are bottom and top surfaces (223, 222) of said circuit board (22), respectively.
